Europäisches Patentamt

European Patent Office

Office européen des brevets

(11) Veröffentlichungsnummer: **0 289 711**

**A2**

## EUROPÄISCHE PATENTANMELDUNG

(21) Anmeldenummer: 88101907.9

(51) Int. Cl.⁴: **G01D 5/20**

(22) Anmeldetag: **10.02.88**

(30) Priorität: 06.05.87 DE 3714993

(43) Veröffentlichungstag der Anmeldung:
**09.11.88 Patentblatt 88/45**

(84) Benannte Vertragsstaaten:
**DE FR SE**

(71) Anmelder: **WABCO Westinghouse Fahrzeugbremsen GmbH Am Lindener Hafen 21 Postfach 91 12 80 D-3000 Hannover 91(DE)**

(72) Erfinder: **Hagen, Detlef, Dipl.-Ing. Hägewiesen 94 D-3000 Hannover 51(DE)**
Erfinder: **Preiler, Ralf, Dipl.-Ing. Limmerstrasse 104 D-3000 Hannover 91(DE)**

(74) Vertreter: **Schrödter, Manfred WABCO Westinghouse Fahrzeugbremsen GmbH Am Lindener Hafen 21 Postfach 91 12 80 D-3000 Hannover 91(DE)**

(54) **Auswerteschaltung für einen induktiven Sensor.**

(57) Es wird eine Auswerteschaltung für einen induktiven Sensor, insbesondere einen Wegsensor vorgeschlagen. Dieser enthält eine vom zu messenden Weg abhängige Induktivität (L). Die Induktivität (L) ist Bestandteil einer Wheatstoneschen Brücke ($R_1$, $R_2$, $R_3$, L). Der Induktivität (L) ist ein Schalter (S) zugeordnet. Die Brückenspannung ($U_A$) wird durch einen Komparator (OP) überwacht. Ein Mikrocomputer (MC) erfaßt die Zeit (T) zwischen der Betätigung des Schalters (S) und dem Nulldurchgang der Brückenspannung ($U_A$). Die Zeit (T) ist proportional dem Wert der Induktivität (L), aber unabhängig vom Wert der Versorgungsspannung ($U_E$).

FIG.1

EP 0 289 711 A2

## Auswerteschaltung für einen induktiven Sensor

Die Erfindung bezieht sich auf eine Auswerteschaltung für einen induktiven Sensor gemäß dem Oberbegriff des Patentanspruchs 1.

Bei derartigen Sensoren, insbesondere Wegsensoren, ist ein Eisenkern in einer Spule verschiebbar gelagert. Je nach Eintauchtiefe des Kerns verändert sich der Wert der Induktivität der Spule. Die Induktivität ist somit ein Maß für die Stellung des Eisenkerns.

Zur Messung bzw. zur Auswertung der Induktivität von induktiven Sensoren sind elektronische Schaltungen bekannt, die nach verschiedenen Meßprinzipien arbeiten. So sind beispielsweise aus der DE-OS 33 43 885 und der DE-OS 35 19 978 Ansteuerschaltungen für einen induktiven Sensor bekannt, bei denen die Spule des Sensors mit einem Spannungssprung beaufschlagt wird. Der Strom in der Spule steigt daraufhin von Null bis auf einen Wert an, der durch eine Strombegrenzung vorgegeben ist. Die Zeit vom Beginn des Stromanstiegs bis zum Ansprechen der Strombegrenzung wird mit Hilfe eines Mikrocomputers gemessen und ist ein Maß für die Induktivität der Spule bzw. die Stellung des Eisenkerns.

Nachteilig bei den bekannten Schaltungen ist deren relativ hohe Abhängigkeit von Schwankungen der Betriebsspannung. Um diese Abhängigkeit zu kompensieren, ist wiederum ein erhöhter Schaltungsaufwand zur Stabilisierung erforderlich.

Der Erfindung liegt die Aufgabe zugrunde, eine Auswerteschaltung für einen induktiven Sensor anzugeben, bei der die starke Abhängigkeit von Schwankungen der Betriebsspannung nicht besteht, und die deshalb entsprechend einfacher aufgebaut werden kann.

Diese Aufgabe wird durch die im Patentanspruch 1 enthaltene Erfindung gelöst. Die Unteransprüche enthalten zweckmäßige Weiterbildungen der Erfindung.

Die Erfindung wird im folgenden anhand einer Zeichnung näher erläutert. Die Zeichnung zeigt in

**Fig. 1** ein Prinzipschaltbild der erfindungsgemäßen Auswerteschaltung,

**Fig. 2** ein Diagramm der Brückenspannung über der Zeit,

**Fig. 3** ein Schaltbild einer real ausgeführten Auswerteschaltung.

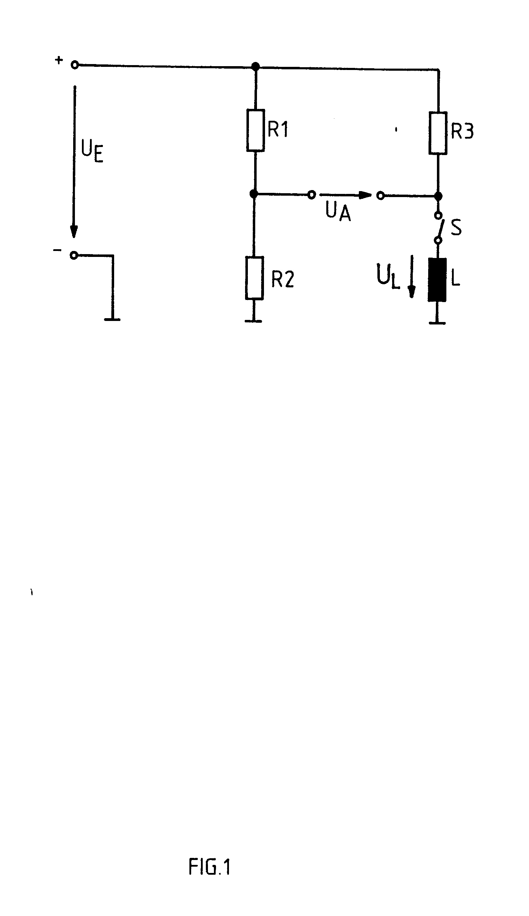

In der Fig. 1 ist ein Prinzipschaltbild dargestellt, welches die grundsätzliche Funktionsweise der Auswerteschaltung gemäß der Erfindung verdeutlicht. An eine Wheatstonesche Brücke, die aus den Widerständen $R_1$, $R_2$, $R_3$ sowie einer Induktivität L besteht, ist eine Versorgungsspannung $U_E$ angeschlossen. An der Brücke kann in bekannter Weise eine Brückenspannung $U_A$ abgegriffen werden. Der Induktivität L ist ein Schalter S vorgeschaltet. Die Induktivität L wird durch die Spule eines Wegsensors gebildet.

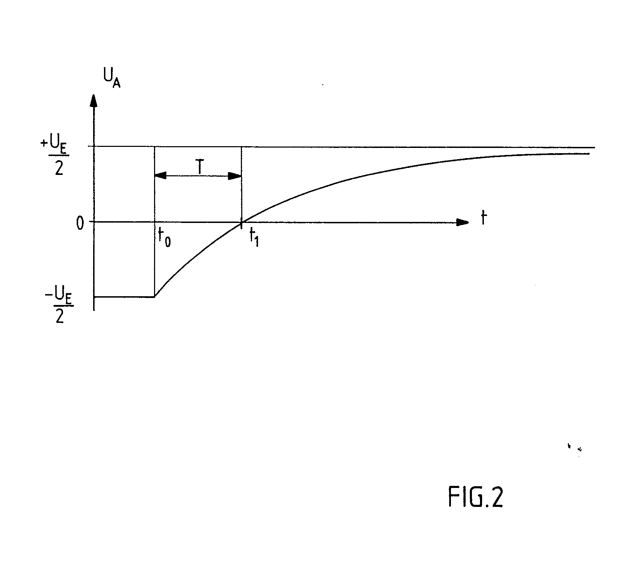

Ein Meßvorgang wird durch das Schließen des Schalters S eingeleitet. Vor dem Schließen des Schalters S hat die Brückenspannung $U_A$ unter der Voraussetzung, daß die Widerstände $R_1$ und $R_2$ den gleichen Wert haben, eine Größe von $-U_E/2$. Mit dem Schließen des Schalters S im Zeitpunkt $t_0$ (vergl. Fig. 2) steigt die Brückenspannung $U_A$ nach einer e-Funktion an. Im Zeitpunkt $t_1$ hat die Brückenspannung $U_A$ den Wert Null erreicht. Im weiteren Verlauf steigt die Brückenspannung $U_A$ bis auf einen Maximalwert von $+U_E/2$ an, wobei eine ideale Induktivität ohne ohmschen Widerstand vorausgesetzt ist.

Die Zeit T zwischen den Zeitpunkten $t_0$ und $t_1$ ist ein Maß für die Induktivität L der Spule des verwendeten Wegsensors und wird durch einen (nicht dargestellten) Mikrocomputer erfaßt und weiter ausgewertet.

Wie im folgenden gezeigt wird, hat die erfindungsgemäße Schaltung den überraschenden Vorteil, daß die Zeit T unabhängig ist von Schwankungen der Versorgungsspannung $U_E$.

Die Brückenspannung $U_A$ (t) errechnet sich zu

$$U_A(t) = \frac{U_E \cdot R_2}{R_1 + R_2} - U_L(t) \quad \text{mit}$$

$$U_L(t) = \frac{U_E \cdot R_i}{R_3 + R_i}\left(1 - e^{-\frac{t}{\tau}}\right) \quad \text{und mit} \quad \tau = \frac{L}{R_3 + R_i}.$$

wobei $R_i$ = Innenwiderstand der Induktivität L.

Die Schaltung wertet den Nulldurchgang der Brückenspannung $U_A$ aus, dann gilt

$$\frac{U_A(t)}{U_E} = \frac{R_2}{R_1 + R_2} - \frac{R_i}{R_i + R_3}\left(1 - e^{-\frac{t}{\tau}}\right) = 0$$

$$\text{d.h., der Ausdruck} \quad \frac{R_2}{R_1 + R_2} - \frac{R_i}{R_i + R_3}\left(1 - e^{-\frac{t}{\tau}}\right)$$

muß zu Null werden.

In diesem Ausdruck ist die Zeit t als einzige Variable vorhanden, es existiert also keine Abhängigkeit von der Versorgungsspannung $U_E$.

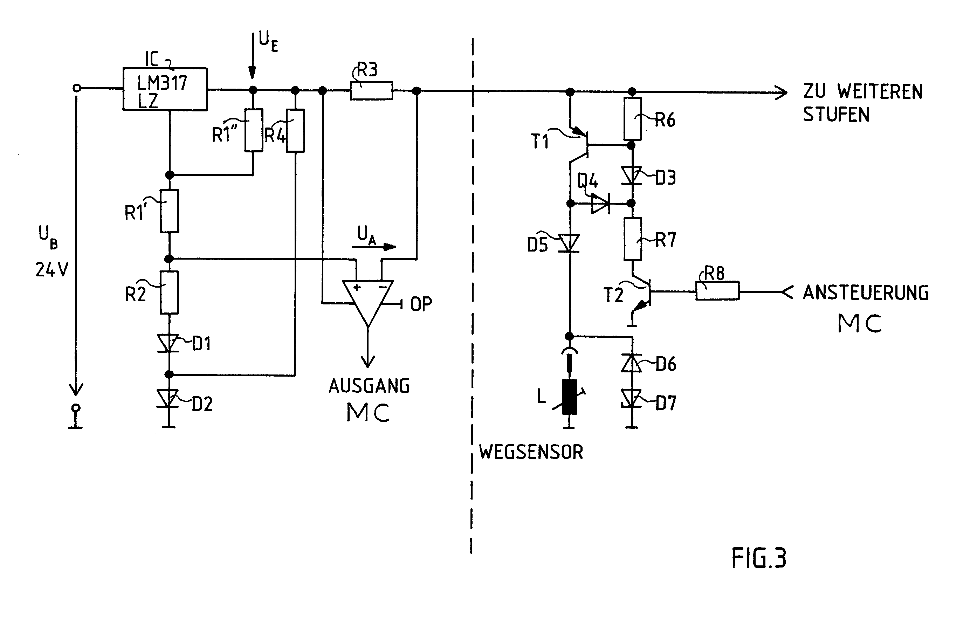

In der Fig. 3 ist ein Beispiel für eine real ausgeführte elektrische Schaltung dargestellt, die nach dem erfindungsgemäßen Meßprinzip arbeitet.

Die Schaltung wird von einer Betriebsspannung $U_B$ (z.B. 24 Volt beim Einsatz in einem Kraftfahrzeug) versorgt. Durch einen Spannungsregler IC (LM317LZ, National Semi Conductor) wird diese Spannung auf einen Wert $U_E$ (z.B. 12 Volt) herabgesetzt. Der Spannungsregler IC ist für die Funktion der Schaltung nicht unbedingt erforderlich. Er dient lediglich dazu, die Belastung der Spule des auszuwertenden Wegsensors zu verringern.

Den linken Zweig der Brückenschaltung nach der Fig. 1 bilden in der Fig. 3 die Widerstände $R'_1$, $R''_1$ und $R_2$.

Den rechten Zweig der Brückenschaltung bilden der Widerstand $R_3$ und die Induktivität L des Wegsensors.

Der Schalter S wird durch einen Transistor $T_1$ gebildet.

Die Brückenspannung $U_A$ wird durch einen Operationsverstärker OP überwacht. Der Zeitpunkt des Nulldurchgangs der Brückenspannung $U_A$ wird durch einen (nicht zeichnerisch dargestellten) Mikrocomputer MC erfaßt, welcher an den Ausgang des Operationsverstärkers OP angeschlossen ist.

Die Dioden $D_1$ und $D_2$ in Verbindung mit einem Widerstand $R_4$ dienen zur Kompensation der Temperaturabhängigkeit des Transistors $T_1$ sowie einer Diode $D_5$. Die Diode $D_5$ dient zum Verpolschutz der Schaltung.

Die Induktivität L ist zur Begrenzung ihrer Abschaltspannung in bekannter Weise mit einer Zenerdiode $D_7$ und einer weiteren Diode $D_6$ parallel beschaltet.

Der Transistor $T_1$ wird über einen zweiten Transistor $T_2$ angesteuert. Die Widerstände $R_6$ und $R_7$ dienen zur Spannungs-Anpassung.

Die Dioden $D_3$ und $D_4$ wirken als Antisättigungsdioden. Der Temperaturgang des Transistors $T_1$ entspricht dadurch dem einer Siliziumdiode und kann dann durch die Diode $D_2$ kompensiert werden.

Die Basis des Transistors $T_2$ ist über einen Widerstand $R_8$ zur Ansteuerung an den Mikrocomputer MC angeschlossen. Die Ansteuerung kann z.B. alle fünf Millisekunden erfolgen. Die Zeit T (vergleiche Fig. 2) bis zum Spannungsnulldurchgang der Brückenspannung $U_A$ kann z.B. 500 $\mu s$ betragen.

Falls mehrere Wegsensoren auszuwerten sind, braucht nur der rechte Teil der Schaltung mehrfach vorhanden zu sein. Die Induktivitäten der Wegsensoren werden dann von dem Mikrocomputer MC nacheinander ein-und wieder ausgeschaltet. Die verschiedenen Meßwerte der Zeit T am Ausgang des Operationsverstärkers OP werden entsprechend zugeordnet. Der linke Teil der Schaltung nach Fig. 3 ist also nur einmal erforderlich.

## Ansprüche

1. Auswerteschaltung für einen induktiven Sensor, insbesondere einen Wegsensor, der eine von einem zu messenden Weg abhängige Induktivität L aufweist, gekennzeichnet durch folgende Merkmale:

a) Die Induktivität (L) ist Bestandteil einer Wheatstoneschen Brücke, die aus den beiden Zweigen $(R_1, R_2)$ und $(R_3, L)$ besteht;

b) die Wheatstonesche Brücke $(R_1, R_2, R_3, L)$ ist an eine Versorgungsspannung $(U_E)$ angeschlossen;

c) der Induktivität (L) ist ein Schalter (S) zugeordnet;

d) die Brückenspannung $(U_A)$ wird durch einen Komparator (OP) überwacht (Fig. 1).

2. Auswerteschaltung nach Anspruch 1, dadurch gekennzeichnet, daß der Komparator (OP) den Nulldurchgang der Brückenspannung $(U_A)$ erfaßt.

3

3. Auswerteschaltung nach Anspruch 1 bis 2, dadurch gekennzeichnet, daß an den Ausgang des Komparators (OP) eine Zeitmeßeinrichtung (MC) angeschlossen ist, welche die Zeit (T) zwischen der Betätigung des Schalters (S) und dem Nulldurchgang der Brückenspannung ($U_A$) mißt.

4. Auswerteschaltung nach Anspruch 1 bis 3, dadurch gekennzeichnet, daß der Brückenzweig ($R_1$, $R_2$) zusätzliche Dioden ($D_1$, $D_2$) enthält, die als Temperaturkompensation für einen Transistor ($T_1$) und eine Diode ($D_5$) dienen (Fig. 3).

FIG.1

FIG.2

FIG.3